# EUROPEAN PATENT APPLICATION

(11) **EP 1 662 411 A1**
(43) Date of publication of application: **31.05.2006**
(21) Application number: 04300813.5
(22) Date of filing: 25.11.2004
(51) Int. Cl.: G06F 17/50

(54) **A validation method for electrical circuits**

(71) Applicant: Renault s.a.s., 92100 Boulogne Billancourt (FR)
(72) Inventor: SNYDER, Ray, 75010, PARIS (FR); BOUTIN, Samuel, 78114, MAGNY LES HAMEAUX (FR)

(57) **Abstract**

The present invention provides a method for designing a validation environment for a service implemented by an embedded electrical system. The method includes the steps of:
a) defining the boundaries of said embedded system;
b) assigning to each device interfaced in use to said system a respective first model, said first model representing the behavior of its associated device;
c) generating automatically a skeleton validation environment around said service and connecting said skeleton validation environment to said interface devices, said skeleton validation environment covering substantially all user requests and resultant system responses of said service;
d) assigning to each electrical source inside said system a respective second model, whose input is a current intensity request (CN) and whose output is a voltage supplied (VS) by said electrical source;
e) assigning automatically to each component of the electrical distribution arrangement of said system, a respective third model representative of the behavior of its associated said distribution component;
f) assigning to each undesired event or behavior of the system a respective fourth model, for which the inputs are all the available signals corresponding to interfaced devices and for which the output signals indicate the occurrence of said undesired event or behavior;
g) connecting all of said first to fourth models together through said skeleton validation environment; and
h) executing test scenarios, said method preferably also including the step of recording from the results of said test scenarios the occurrences of undesired behavior resulting from an undesired event or fault.

## Description

### FIELD OF THE INVENTION

The present invention relates to validation methods for electrical circuits and in particular to the design of a validation environment for a service implemented by an embedded electrical system.

### BACKGROUND TO THE INVENTION

In many fields, including the automotive domain, the design of an electrical distribution system has become very complex in recent years for a variety of reasons.
- The number of components used has increased.
- Interactions between electronic and electrical systems have increased.
- Components with different safety or availability constraints are connected to the electrical distribution system and the partitioning of components in the electrical circuit must preserve these constraints. For instance, an important control unit should not be protected by the same fuse as a less important component.
- Difficulty has increased in anticipating the sources of errors.
- There is an increasing need for an efficient diagnosis when a system is faulty.
- Cost pressure is high. An economic optimum is always looked for.
- Diversity management increases the workload. The electrical architecture has to be scalable to cope with the mix of options. For instance, if a climate control system is mounted on 10% of the cars, then the electrical components which are specific to this feature will be isolated and for instance will have specific connectors because for 90% of vehicles, they will not be used.

Due to this level of complexity and to the diversity of such systems, it is difficult to test exhaustively all the components and variants. To cope with this, a general trend is to rely more and more on simulation. However, many problems arise:
- Who writes the models? Due to the number of tests to be performed, the construction of simulation models should be partly automated but how is this possible?
- Which tools and simulations can we rely on and for what purpose?
- Are the simulations sufficiently efficient and precise?
- Can we test all the standard failures with these models?
- How can we put all the test results together to know whether an electrical distribution is sufficiently available and safe?

It happens that no known solution really copes with all these problems at present. Different tools and methods have been developed for electrical systems design and testing, in an attempt to reduce the effects of one or more of the known limitations. At the design level, for example, some methods and tools allow simulating very accurately the behavior of an electric system. The main techniques available will now be briefly summarized.

Network analyzers like Spice or Saber are based on flow conservation at each node of a graph. In this domain, VHDL-AMS is a rising standard. Information about the VHDL-AMS standard can be found via the IEEE 1076.1 Working Group by accessing the Internet web page:
www.eda.org/vhdl-ams/

Such analyzers are commonly used for micro electronics components design. In this market, some of the tools fit very well for an accurate simulation of an electrical circuit.

Signal processing design tools, like Matlab/Simulink, are based on signal propagation analysis. This kind of techniques is very efficient but does not match fully the behavior of electrical circuits. Unfortunately, the electric signals on a wire can propagate in both directions and the measurement of intensity and voltage in a circuit cannot be specified obviously as a local phenomenon. New libraries in Matlab/Simulink allow bidirectional signal processing. However, it is very clear that these developments do not have a sufficient maturity for large (even small in our opinion) scale use. The main application of Matlab/Simulink is found for control design, i.e as a tool for the design of software specifications.

Matlab/Simulink and Matlab/Stateflow are commercial products available for supporting simulation of mechatronic systems (mixed mechanical and electronic). Information can be found for example by accessing the Internet web page:
http://www.mathworks.com

"Bond graphs" is a formalism in which flow and energy conservation at each node of a graph are specified. It covers the same domain as network analyzers and consists of a very similar approach. Information about "Bond graphs" can be found by accessing the Internet web page:
http://www.bondgraphs.com/about.html

If we were to simulate a complete system, electrical circuits are easily specified and simulated in Bond graphs or network analyzers. Software and electronic components are well specified using Signal processing design methods or using automata formalism. Mechanical systems can be specified using each of the above mentioned formalisms depending on the needs of the simulation. Thermodynamics and Hydraulics are preferably specified using Bond graphs but may also be properly specified using signal processing design tools.

Two further remarks deserve to be made:
- Due to their different nature and approaches, it is very difficult to make all these tools or approaches interact. Their intrinsic computation approach is different. This is also a practical difficulty which is not overcome by any approach or tooling today.
- Mechanics, Thermodynamics and Hydraulics are domains in which failure probabilities are well mastered compared with electrical and electronic systems: it is relatively simple to diagnose a mechanical failure or a leak in a hydraulic system, or even to predict the reliability of such systems in advance. This means that fault modeling is preferably needed for the modeling of electrical and electronic parts of a system.

It can therefore be seen that there is a continuing need for improved methods for a uniform design of electrical systems testing which allows the system model and its physical representations to be validated at the different steps of its realization, especially in the case of distributed functions design.

### SUMMARY OF THE INVENTION

It is an object of the present invention to provide an improved method for the validation of system design and in particular for the design of an improved validation environment for a service implemented by an embedded electrical system.

Accordingly, the present invention provides a method for designing a validation environment for a service implemented by an embedded electrical system, the method including:
a) defining the boundaries of said embedded system;
b) assigning to each device interfaced in use to said system a respective first model, said first model representing the behavior of its associated device;
c) generating automatically a skeleton validation environment around said service and connecting said skeleton validation environment to said interface devices, said skeleton validation environment covering substantially all user requests and resultant system responses of said service;
d) assigning to each electrical source inside said system a respective second model, whose input is a current intensity request (CN) and whose output is a voltage supplied (VS) by said electrical source;
e) assigning automatically to each component of the electrical distribution arrangement of said system, a respective third model representative of the behavior of its associated said distribution component;
f) assigning to each undesired event or behavior of the system a respective fourth model, for which the inputs are all the available signals corresponding to interfaced devices and for which the output signals indicate the occurrence of said undesired event or behavior;
g) connecting all of said first to fourth models together through said skeleton validation environment; and
h) executing test scenarios, said method preferably also including the step of recording from the results of said test scenarios the occurrences of undesired behavior resulting from an undesired event or fault.

By correcting early mistakes in the design process, the method of the present invention allows time to be saved in the system design and development. It also improves testing coverage and so also the quality of the testing. The system may comprise a system used in a vehicle, such as for example a safety critical and/or fault tolerant system, e.g. brake-by-wire.

The interfaced devices may include at least one selected from the group including; mechanical, optical, hydraulic, pneumatic or thermal devices.

The method may include the injection of simulated faults, corresponding for example to a short circuit in the case of wiring, an increased resistance due to corrosion for connectors or an open circuit.

The method may include outputting a design of a validation environment for use in adaptation of a design tool to perform validation testing of a said embedded electrical system.

The method may include substituting one or more of said models with a corresponding software implementation and performing software-in-the-loop testing so as to validate the software implementation.

The method may include substituting one or more of said models with a corresponding hardware implementation and performing hardware-in-the-loop testing so as to validate the hardware implementation.

The method may include producing a design of a wiring harness for a vehicle and using said hardware-in-the-loop environment for validating the specification of wiring and connectors.

The present invention also provides a computer readable memory having encoded thereon a program for the design of a validation environment for a service implemented by an embedded electrical system, characterized in that said program includes:
a) code for defining the boundaries of said embedded system;
b) code for assigning to each device interfaced in use to said system a respective first model, said first model representing the behavior of its associated device;
c) code for generating automatically a skeleton validation environment around said service and connecting said skeleton validation environment to said interface devices, said skeleton validation environment covering substantially all user requests and resultant system responses of said service;
d) code for assigning to each electrical source inside said system a respective second model, whose input is a current intensity request (CN) and whose output is a voltage supplied (VS) by said electrical source;
e) code for assigning automatically to each component of the electrical distribution arrangement of said system, a respective third model representative of the behavior of its associated said distribution component;
f) code for assigning to each undesired event or behavior of the system a respective fourth model, for which the inputs are all the available signals corresponding to interfaced devices and for which the output signals indicate the occurrence of said undesired event or behavior;
g) code for connecting all of said first to fourth models together through said skeleton validation environment; and
h) code for executing test scenarios, preferably further including code for recording from the results of said test scenarios the occurrences of undesired behavior resulting from an undesired event or fault.

The program may further include code for the injection of simulated faults, corresponding for example to a short circuit in the case of wiring, an increased resistance due to corrosion for connectors or an open circuit.

The present invention also provides a design tool adapted for the validation of a system design, said design tool being arranged in use to output a validation environment for an embedded electrical system by using a method according to the present invention, or through being programmed using an article of commerce according to the present invention.

### BRIEF DESCRIPTION OF THE DRAWINGS

The present invention will now be described by way of example only, with reference to the accompanying drawings, in which:
Figure 1 illustrates the specification of a global electrical distribution;
Figure 2 illustrates the behavior of an electrical source;
Figure 3 illustrates a detailed electrical circuit;
Figure 4 illustrates a formalism to describe splices and wires;
Figure 5 illustrates a language translating the electrical distribution specification in an executable model;
Figure 6 illustrates in 6A to 6C the interpretation of a splice;
Figures 7 illustrates in 7A to 7C the interpretation of a fuse;
Figure 8 illustrates in 8A to 8C the interpretation of a wire;
Figure 9 illustrates in 9A to 9C the interpretation of a Relay or of a Smart Transistor;
Figure 10 illustrates in 10A to 10C the interpretation of an open circuit on a wire;
Figure 11 illustrates in 11A to 11C the interpretation of a short circuit to ground close to a splice;
Figure 12 illustrates in 12A to 12B the interpretation of corrosion, e.g. on a pin of connector;
Figure 13 illustrates an alternative interpretation of splices;
Figure 14 illustrates in 14A to 14B a simplified simulation of corrosion on a wire;
Figure 15 illustrates in 15A to 15D the interpretation of the impedance of electrical components;
Figure 16 illustrates in 16A to 16B the interpretation of corrosion when integrating impedance in the interpretation;
Figure 17 illustrates the layout of a testing environment for an electronic controlled system; and
Figure 18 illustrates the process implementing the validation method of the present invention.

### DETAILED DESCRIPTION OF A PREFERRED EMBODIMENT

An electronic system is made of Electronic Control Units (ECU), which may or may not be networked through communication busses, sensors, actuators, and electrical devices providing power to the different system components for example wiring, connectors, relays, fuses, battery and alternator. Also, actuators and sensors are the interface between electronics and the physical world. In order to simulate a complete system, it is necessary to include in the simulation the physical components and their interaction with the user and other parts of the system environment.

Practically, the most difficult point today is to gather together the models of all the parts of a system. One of the most difficult parts to model is the electrical circuit, in particular its interpretation in a signal processing modeler.

In this description we explain how we alleviate this problem and provide a process to verify, with or without the presence of fault, an electrical circuit and so a complete electronic system. The present invention is particularly concerned with validation models for embedded electrical systems. An embedded system exists in a larger system, with the purpose of helping that system to achieve its overall responsibilities. An embedded code is the software program of an embedded system. We mainly talk about embedded real-time systems, which means embedded systems that have performance deadlines on their computations and actions. It will be appreciated that the electrical systems concerned may be in particular interacting with electronic components.

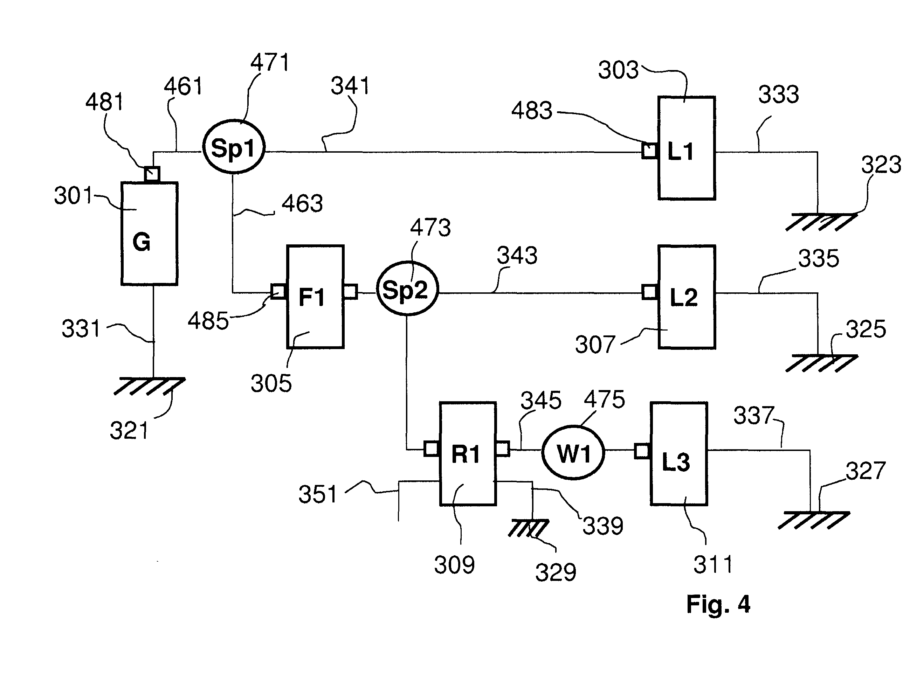

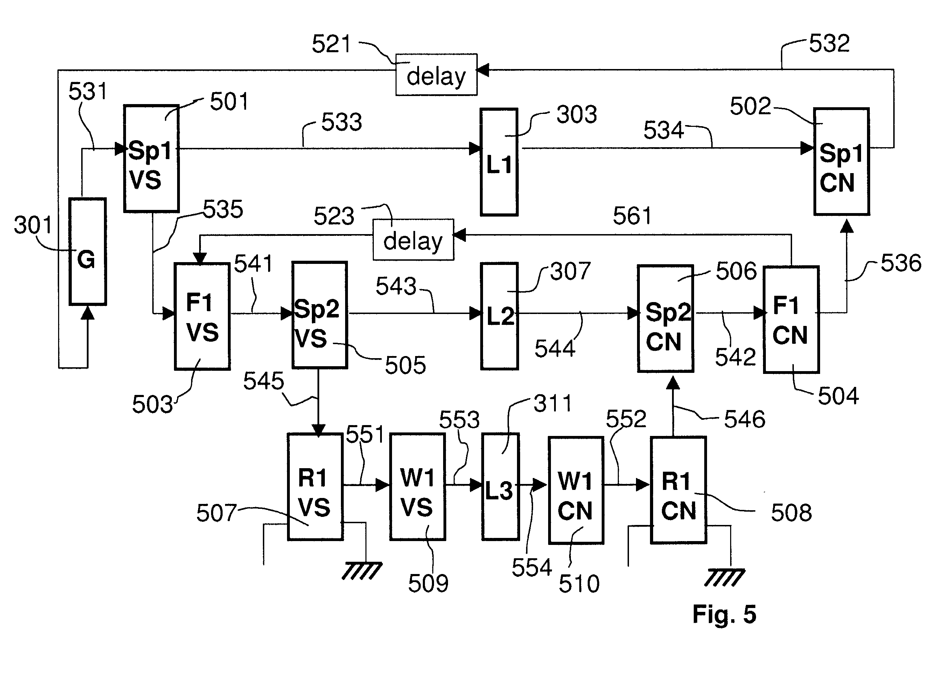

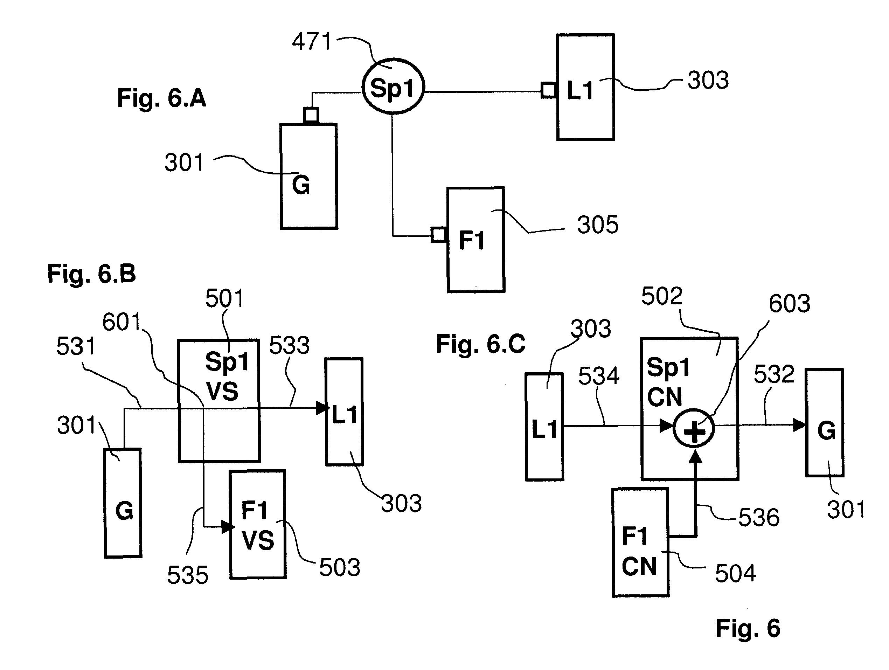

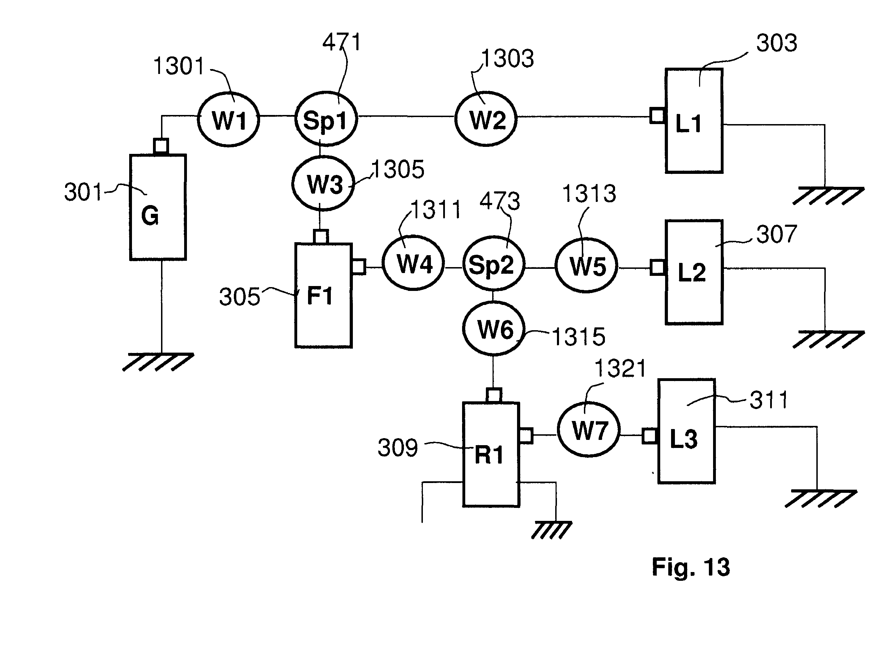

The description of an electrical circuit can be translated automatically into a signal processing model. This model is well suited to monitor stationary states of the electrical circuit. It allows a sound modeling of electrical faults like short circuits, open circuits and corrosion. Last but not least, it remains simple and allows a very efficient simulation. The principle of the translation of the description into a model is specified in Figures 4 and 5. The interpretation of the typical electrical components is specified in Figures 6 to 9. Figure 13 proposes an alternative interpretation of splices, one of the electrical components that deserve to be modeled automatically.

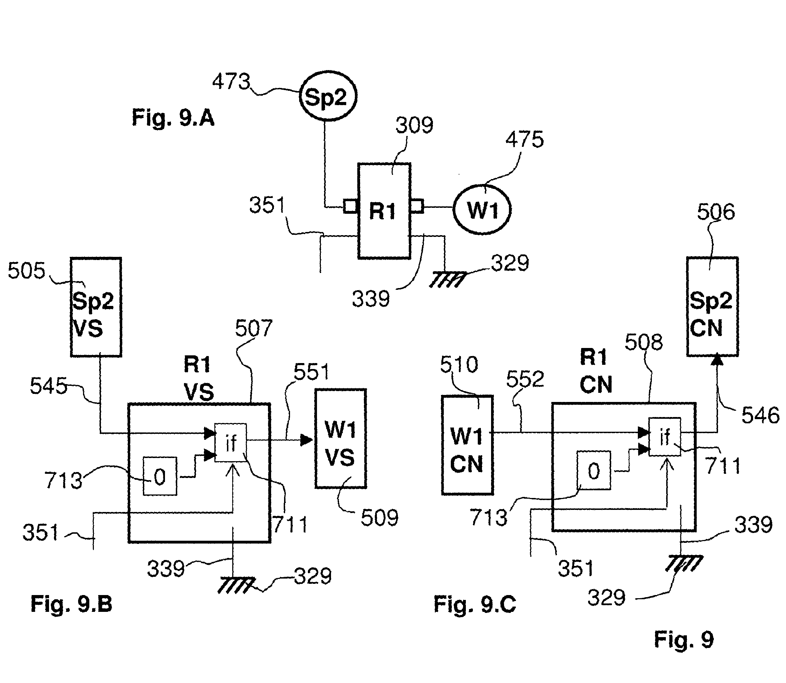

Given this key element, the electrical distribution model can be used in a model in the loop simulation to inject faults and detect early mistakes in the design of a new system. The modeling of electrical faults is specified in Figures 9 to 12.

A side effect of the automatic building of electrical circuit modeling is that it is then possible to use a single formalism (signal processing approach) to model a complete system despite the different domains combined. This is very important for the sake of efficiency. Matiab/Simulink can be used as a solver for the simulation. It is at present one of the most mature approaches for simulation.

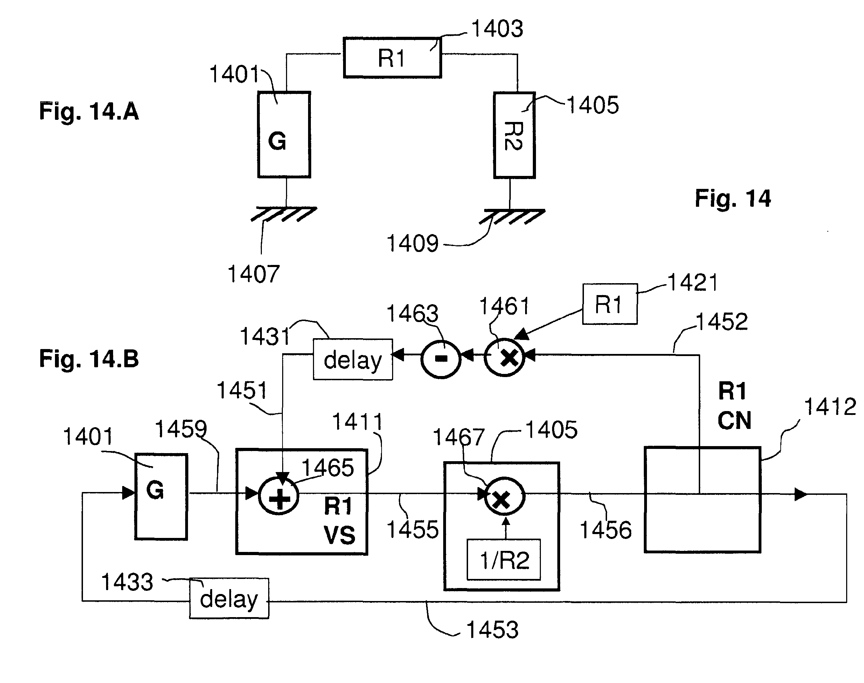

When building a simulation, one of the main focuses is the stability of the simulation. Figure 14 highlights this problem by providing an example which may be unstable depending on the parameters.

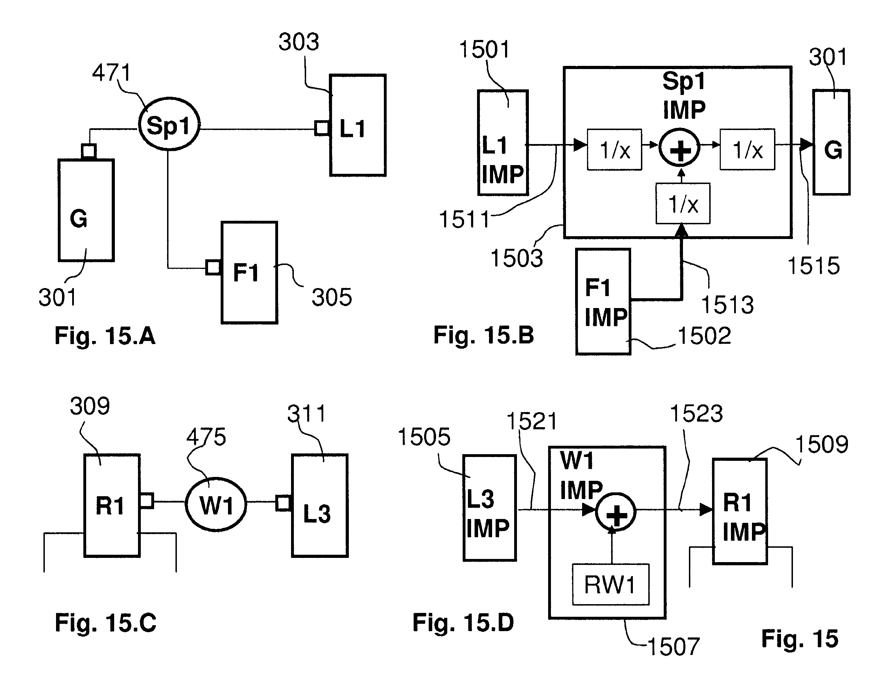

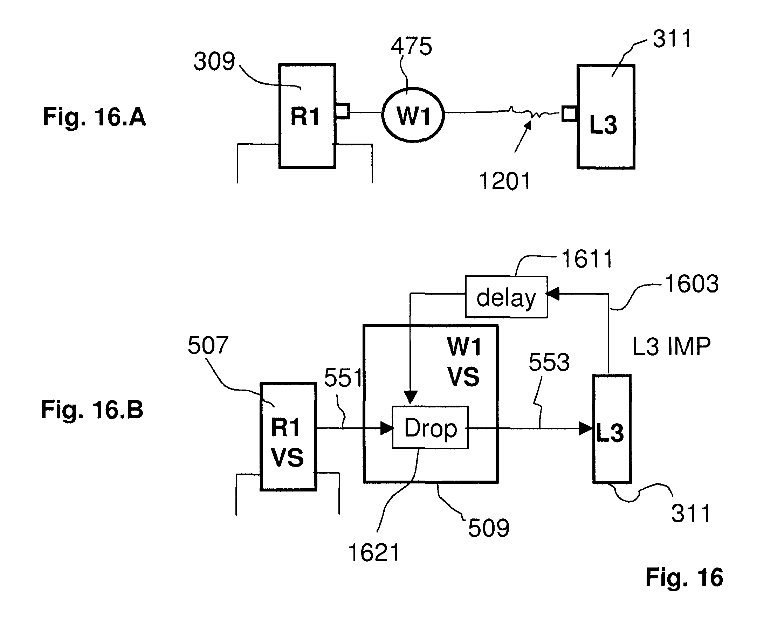

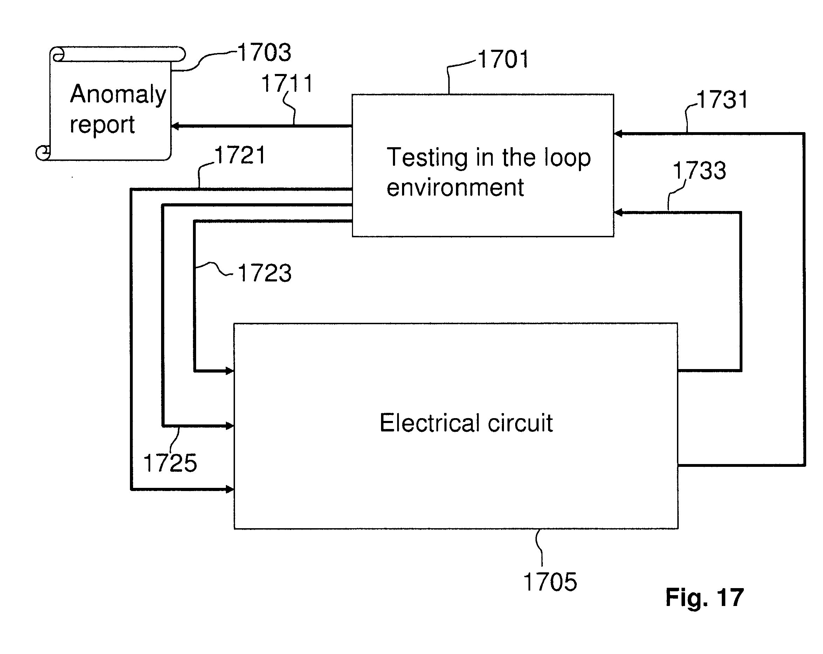

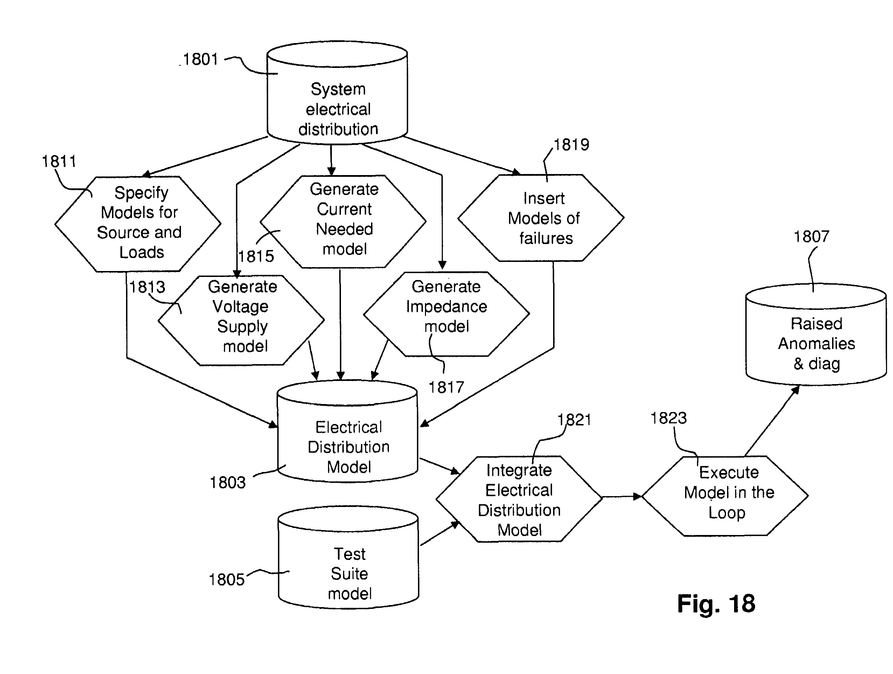

This leads to the specification and use of impedance in the interpretation of components as a complement to Intensity and Voltage flows. The Impedance interpretation is shown in Figure 15. Figure 16 shows how some Voltage flows should be modified in the case where Impedance is included in the modeling. Finally, a reminder of the process and global picture are explained in Figures 17, 18.

Validation of a system consists of proving, by means of simulation and testing, as exhaustively as possible, that the service requirements are properly covered by their implementation in a system. Validating a service can be performed at different stages of the design and by different approaches. When the service is modeled, the model may be validated in a virtual environment. This is called "Model in-the-loop". Then, when the software implementing the service is produced, it can be accommodated in a model and validated. This is called "Software in-the-loop". Then when the hardware is designed, the environment can again be simulated in hardware environment which is interfaces to the system. This is called "Hardware in-the-loop Validation". The environment of the system is then called a "Hardware in-the-loop" environment or simply "HIL". These different techniques can be combined with the simulation of the electrical circuit as described here.
Information about "Hardware in-the-loop" (HIL) testing can be found by accessing the Internet web page:
http://**www**.dspaceinc.com/**ww**/enlinc/home.htm

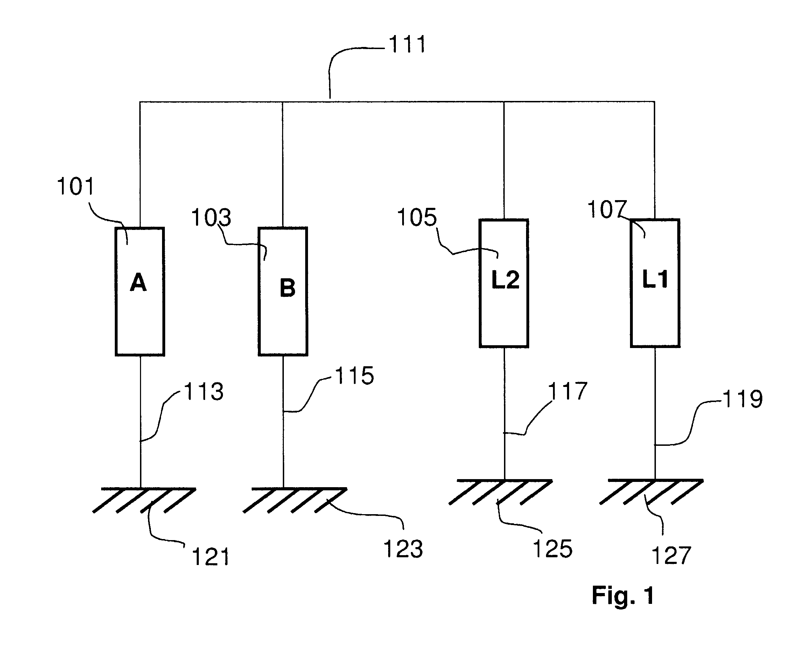

Referring now also to the other figures, and in particular for the moment to Figure 1, a rough description of an electrical distribution in a car is presented. Outlines 101 represents an alternator A and outline 103 a battery B. Outline 105 and 107 represent electrical loads in vehicle like heating resistors or electrical engines used e.g. for wiping. In a typical electrical distribution system, some of the loads can be activated all the time, e.g. L1 and some others only when the alternator is delivering power e.g. L2. This is possible through the use of switches and relays which are not presented in Figure 1. The current between sources and loads is circulating on wire 111. Of course, voltage is maintained through a connection to vehicle mass (121, 123, 125, 127) through wires 113,115,117and119.

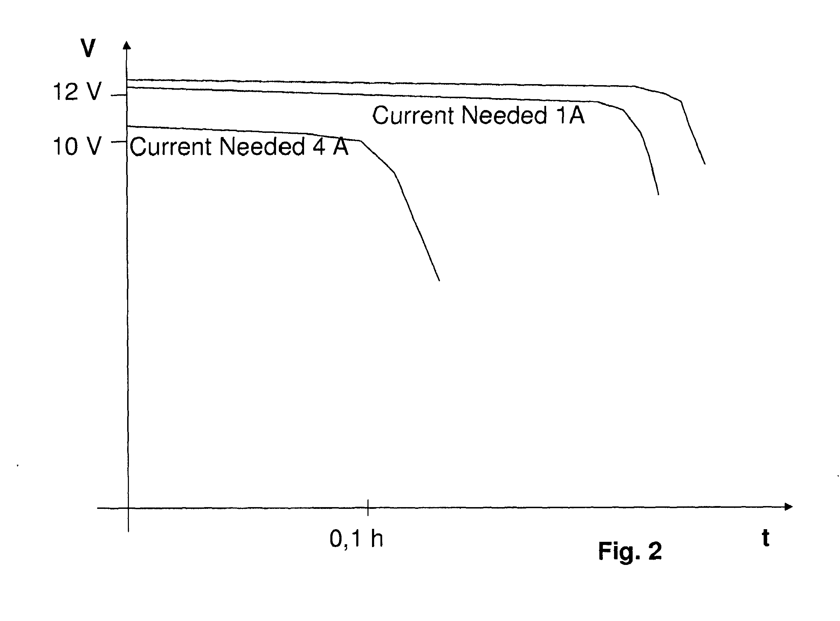

In Figure 2, a map of the voltage delivered by a battery depending on the current needed and the duration of the demand is presented. This is typically a model for a source of power which can be used in the models built following the invention. A battery will be interpreted as a model with as its input a current needed and as its output a voltage supplied as a function of time.

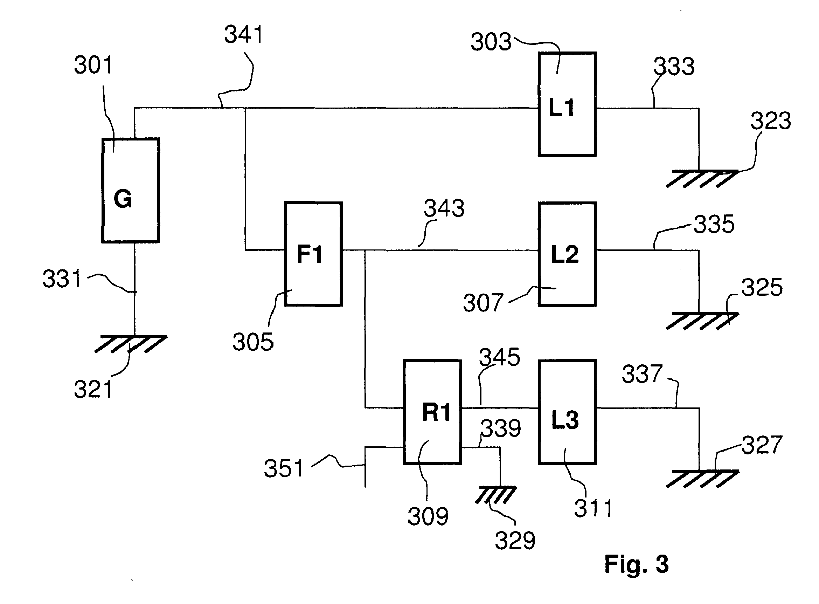

In Figure 3, an electrical circuit is described. The electrical source G (301) may be a battery for instance. The circuit contains electrical loads L1 (303), L2 (307) and L3 (311). The circuit also includes fuse F1 (305) and relay R1 (309). According to the topology of the circuit, fuse F1 is protecting loads L2 and L3 and load L1 is not protected. The mass (also known as common ground, earth or chassis) of the system is represented by symbols 321, 323, 325, 327 and 329 and the different components are linked to the mass through wires 331, 333, 337 and 339.

The distribution of the current is performed through wires 341, 343, 345. Wire 341 and 343 include splices (SP) which means there is a "1:n" connection between the source and the loads. Behavior of Relay R1 is controlled by wire 351, which is typically a signal coming from a microcontroller. Relay R1 can be embedded in an electronic control unit (ECU). This simple circuit will serve as a basis for the description of the interpretation of electrical circuits that we are using for our verifications. As our interpretation is generic, it will extend systematically to circuits of any complexity. The only condition is that the circuit be presented in the form of a source on one hand, a set of loads on the other hand and a loop free circuit in the middle.

In Figure 4, the circuit presented in Figure 3 is detailed. First, splices are formalized. Blocks Sp1 (471) and Sp2 (473) represent splices. Sp1 connects source G with load L1 and Fuse F1. Sp2 connects Fuse F1 with load L2 and relay R1. Second, connection pins are specified at the interface between wires and components. For instance, pin 481 is the interface between generator G (301) and splice Sp1 (471). Although we will neglect these connection pins in the following, for the sake of simplicity, their importance remains in the fact that they may be affected by corrosion. Corrosion is a kind of error which can be simulated. In the exhaustive testing in the presence of a fault, each connection pin may be interpreted as an over resistance of the corresponding wire. A wire deserves a special interpretation in our model. We must be able to take into account failures like open circuit (OC) or short circuit (SC). So the connection between relay R1 and load L3 is specified as an explicit component: wire W1 (outline 475).

In Figure 5, the interpretation of the circuit presented in Figures 3 and 4 is presented. As can be seen, the interpretation of source G is a block G (301) with same number of inputs and outputs. Also, loads L1, L2 and L3 of Figure 3 are interpreted as outlines respectively L1 (303), L2 (307) and L3 (311).

In Figure 5, source G input 532 corresponds to the current needed by the circuit and G output 531 corresponds to the voltage that source G can supply for a given current need. During the initialization of a simulation, a first Voltage supplied must be emitted without getting yet the corresponding current request. For the first value, an average value (say a nominal 12V for a battery) should be specified for the initialization of the simulation.

L1 input 533 corresponds to a voltage supplied and L1 output 534 corresponds to a current needed. Similarly, all the loads are interpreted as functions of time, getting as input a voltage supplied (VS) and yielding as output a current needed (CN). For instance, in the case of a resistor valued R, the current needed (CN) for input voltage "V(t)" at a given moment t, is V(t)/R. So, in Figure 5, output 544 of L2 and output 554 of load L3 are current needed; and input 543 of L2 and input 553 of L3 are voltages supplied to these loads.

So we have seen the interpretation of sources and loads. We are now describing the interpretation of other key components: splices, wires, Fuses, Relays. Each of these components yields two models: one propagating the voltage supplied (VS) and the other one propagating the current needed (CN). This results in a symmetric model interpretation as represented on Figure 5. For instance, Blocks "Sp1 VS" 501 and "Sp1 CN" 502 are the two parts forming the interpretation of splice Sp1 in Figure 4. They are more or less symmetric as "Sp1 VS" propagates a voltage supplied from the source to the loads and "Sp1 CN" propagates a current needed from the loads to the source. So in the diagrams, the blocks and flows in between the source G and the loads L1, L2 and L3 perform the voltage supplied propagation (resulting in the acronym VS in the blocks) and symmetrically, the blocks and flows "after" the loads correspond to the current needed propagation from the loads to the source (resulting in the acronym CN). It would be possible to gather together the voltage supplied parts and the current needed parts to get a more compact representation but this would not improve readability.

We now focus on the interpretation of the components that form the electrical distribution.

We have already seen that a splice is shown in the diagram by two related blocks. For instance, Splice Sp2 is interpreted as two blocks: "Sp2 VS", outline 505 and "Sp2 CN", outline 506. Outline Sp2 VS takes as input the voltage supplied from block "F1 VS", outline 503, through flow 541. So this flow is carrying a voltage supply from its producer to its consumer. Sp2 VS forward a voltage supply to load L2 through flow 543 and to block "R1 VS", outline 507, through flow 545. R1 VS is the voltage part of the interpretation of relay R1 in Figure 3 and 4. The content of block Sp2 VS will be specified further on. As for Sp2 CN, it has a symmetric interpretation of Sp2 VS. While Sp2 VS receives a voltage supply from block F1 VS which partly implements fuse F1, "Sp2 CN" transmits a current needed to block F1 CN which implements the remaining part of fuse F1, through flow 542. Similarly Sp2 CN receives a current needed request from L2 and R1 CN, outline 508, through respective flows 544 and 546.

A fuse can be interpreted as two related blocks, one interpreting the voltage supply propagation and the other the current needed propagation through the circuit. Again this can be specified in the form of a symmetric construction, the Voltage supply part being an image of the current needed, with the input on one side becoming output on the other. So Fuse F1 is translated into: F1 VS, outline 503, and F1 CN, outline 504. F1 VS receives a voltage supply from splice Sp1 interpreted as Sp1 VS through flow 541 and transmits a voltage supply to splice Sp2 interpreted as Sp2 VS through flow 541. In the other side, F1 CN transmits a current need to splice Sp1 interpreted as Sp1 CN through flow 536 and receives a current needed from splice Sp2 interpreted as Sp2 CN through flow 542. The description of the internal behavior of F1 VS and F1 CN is presented latter. However, it is still necessary to explain flow 561 and outline 523 which represent a feedback loop from F1 CN to F1 VS. In fact, a fuse may blow in case it has to support excessive current for too long. When the fuse has blown, its behavior changes, it is no longer an active part of the circuit. So flow 561 contains the information whether the fuse has blown or not. Outline 523 is a delay block; in case we want to make a simulation, blocks and flows 503, 541, 505, 543, 307, 544, 506, 542, 504 and 561 form a loop so that no initialization is possible. Inserting a delay block 523 allows breaking the loop in order to allow simulation. Delay blocks are specific to signal processing execution. Such blocks allow scheduling the evaluation of other blocks. Delay blocks are commonly used in Matiab/Simulink to implement control loops.

A relay can also be interpreted as two symmetric blocks, one operating the voltage supply propagation while the other operates the current need propagation. For instance, relay R1 is interpreted as a couple of blocks: R1 VS, outline 507, operates the voltage supply propagation and R1 CN, outline 508 operates the current need propagation. The behavior of these blocks will be explained latter. The signal commanding the relay, which is of much lower power, is not mentioned in Figure 5. The interpretation we present here is sound for both electrical circuits and low power signals, but modeling of defects on the low power wires do not require a complex modeling and the topology of the signal wires is often very simple: it corresponds to a one producer - one consumer link. So practically we will consider that the low power signals are interpreted as simple flows, but nothing would prevent a more accurate interpretation. So, flow 351 is common on the voltage and current sides in Figure 5. Its real interpretation will be clear when we will describe the behavior of R1 VS and R1 CN.

A wire deserves a special interpretation in our model. We must be able to take into account failures like open circuits or short circuits. In Figure 5, we see that wire W1 is interpreted as a couple of blocks: W1 VS, outline 509, for the voltage supply propagation and W1 CN, outline 510, for the current need propagation. Again these two blocks are symmetric. This is obvious here as they are on each side of load L3. The interpretation of wire blocks will be specified latter.

We now turn to a thorough description of the interpretation of each electrical component (source, loads, fuses, relays, wires, splices). In Figure 2 we already explained the model for a source. Above, a sample of interpretation for load L1 has been presented. Basically, a source is interpreted as function of time generating a voltage supplied given a current needed. Conversely a load is interpreted as a function of time generating a current needed given a voltage supplied. Of course, during a simulation, there is a regulation between the source and the loads. If the loads ask for more current, the voltage will drop resulting in the loads lowering their current need. The convergence of this regulation will be discussed with Figure 14. Practically, the results are good for an electrical circuit embedded in a car. So we now have to explain the interpretation of splices, fuses, wires and relays.

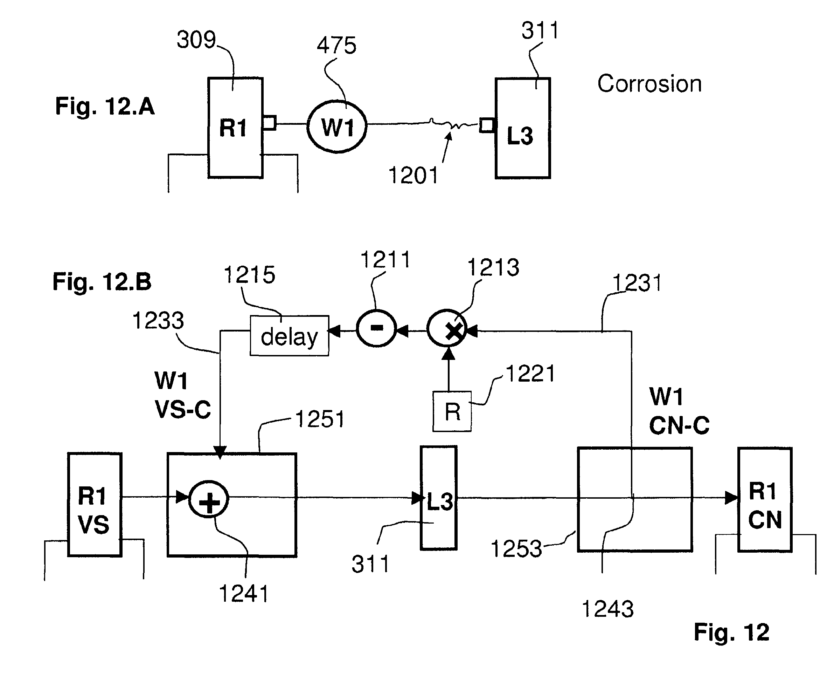

In Figure 6, we describe the behavior of blocks Sp1 VS and Sp1 CN that we have already seen in Figure 5. Outline 501 in Figure 6.B is now transparent and we can see that the voltage supply output flows 533 and 535 are equal (601) to the voltage supply input flow 531 of Sp1 VS. In this case we neglect the resistance of the wires. However, looking at the interpretation of corrosion as a resistance on a wire in Figure 12, it is obvious how this interpretation should be modified to take into account a wire resistance. This implementation is very natural: no potential is lost when traversing a negligeable resistance splice or wire in a circuit. Outline 502 in Figure 6.C is now transparent and we see that current need output flow 532 is equal to the sum (603) of the currents needed by the input flows of a splice, here 534 and 536.

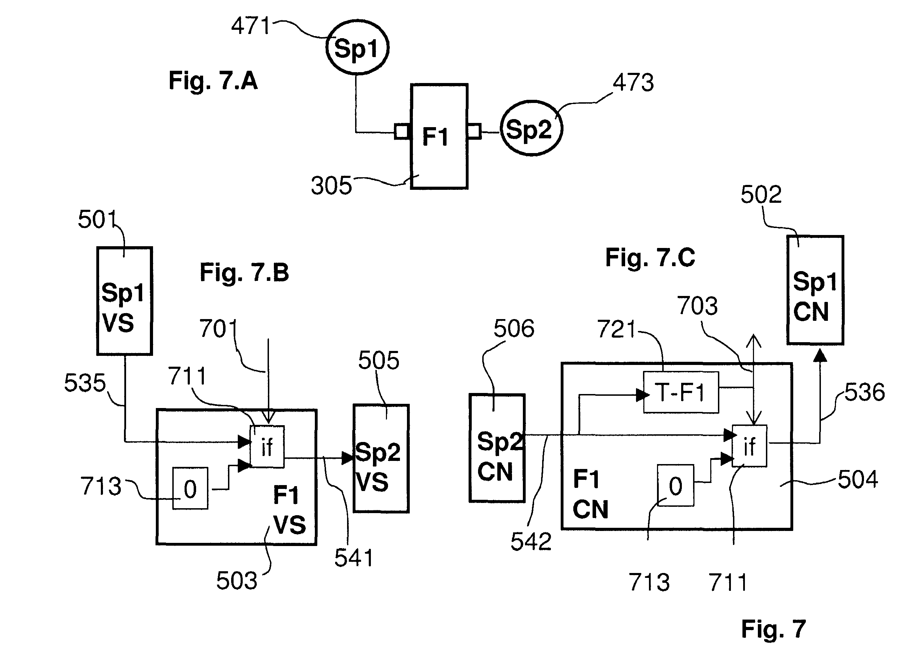

In Figure 7, the interpretation of a Fuse is presented. The behavior of Fuse F1, already introduced previously is detailed. In the voltage supply propagation view, F1 VS (503) is propagating on its output 541 the same voltage supply as the one specified on its input 535 except if (711) the Fuse is blown, in which case the voltage supplied on the output 541 is zero (713). The information whether the fuse is blown is received from flow 701. This flow is in fact the same as flow 703 emitted by F1 CN (504) in Figure 7.C. If we now look at F1 CN, we see that a function T-F1 (721) is consuming the input current needed (542). This function of time is yielding a Boolean flow 703. This Boolean is true if the integration of the current over a predefined period is higher that a predefined threshold which are parameters of the fuse. Both that period and that threshold define the maximum level of current accepted by the Fuse. Once this level is reached, the fuse is considered as blown. So the current output flow 536 is equal to the current input flow 542 as long as the fuse is not blown. If (711) the fuse blows, the output flow 536 is null (713).

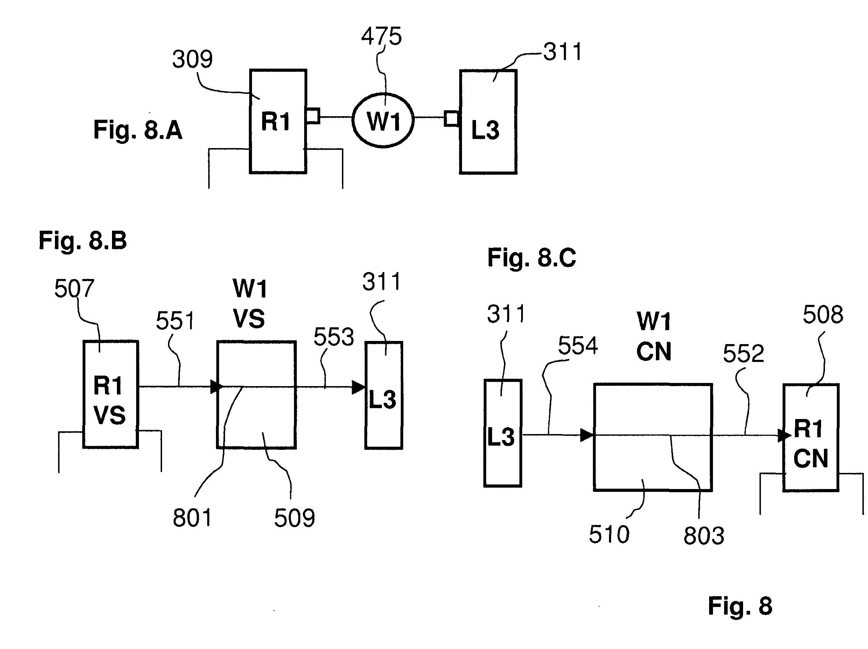

In Figure 8, the interpretation of wire W1 (475 in Fig. 8.A) is presented. This interpretation is trivial in the absence of fault. A wire W1 is the identity both for the voltage supply and the current need. So in Figure 8.B, the output voltage flow 553 of W1 VS, 509, is simply equal (801) to the input voltage flow 551. Similarly, in Figure 8.C, the output current flow 552 of W1 CN, 510, is equal (803) to the input current flow 554. We will see that the interpretation is more complex when we need to simulate open circuits or short circuits.

In Figure 9, the interpretation of a relay is described. A relay behaves like a wire or an open circuit depending on the value carried on flow 351. In Figure 9.B, the output flow 551 of the voltage supply propagation of R1, named R1 VS, drawn in outline 507, is equal to the voltage supply input flow 545 if (711) the value carried on 351 is triggering the Relay, and null (713) otherwise. Note that the interpretation of flow 339 and 329, which represent the link of the command layer to the mass, is neglected in the interpretation. The interpretation of R1 CN, in Figure 9.C is straightforwardly similar, taking into account the symmetry between the Current and Voltage interpretations. Note that the interpretation of a Relay extends simply to the interpretation of a transistor or a switch.

We have shown how an electrical circuit can be modeled faithfully through an interpretation of each element of that circuit. However, the purpose of this interpretation is to validate both nominal behavior and behavior in the presence of faults. We now specify how typical electrical failures can be specified, modeled and executed faithfully under this interpretation.

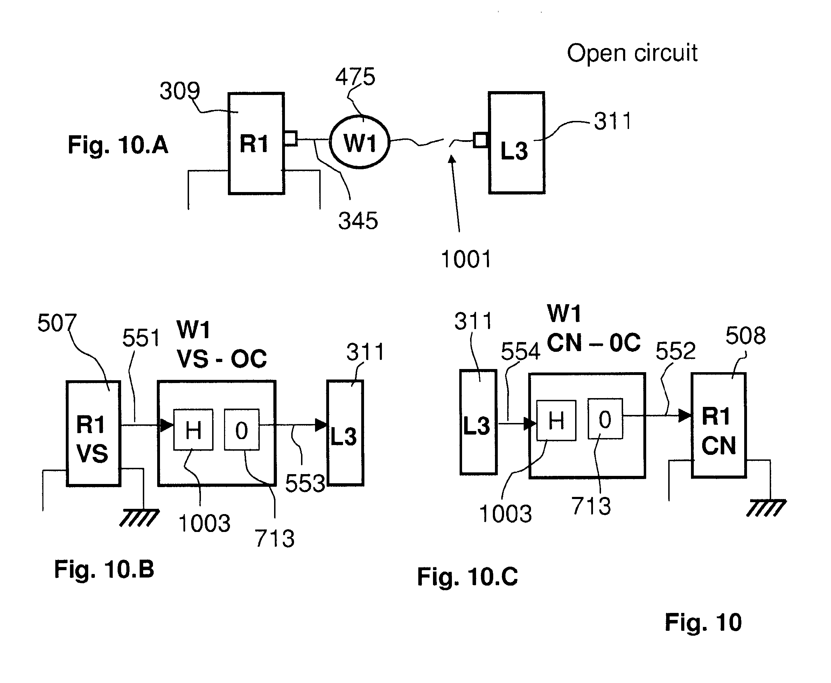

In Figure 10, an open circuit is modeled. Figure 10.A shows wire W1 (475) cut, resulting in an open circuit. In that case, load L3 would not be fed anymore with current and voltage. So the interpretation of an open circuit (OC) on a wire in the voltage propagation, W1 VS-OC, is shown in Figure 10.B. Flow 551, which is the voltage input flow of the wire is terminated in function H (1003). A null voltage (713) is propagated along the flow 553 and received by Load L3. Symmetrically, in Figure 10.C, the interpretation of the open circuit on a wire in the current need propagation, W1 CN-OC, is exactly the same. Current required from the open circuit through flow 552 is null (713) and the need that may come from flow 554 is simply ignored (1003).

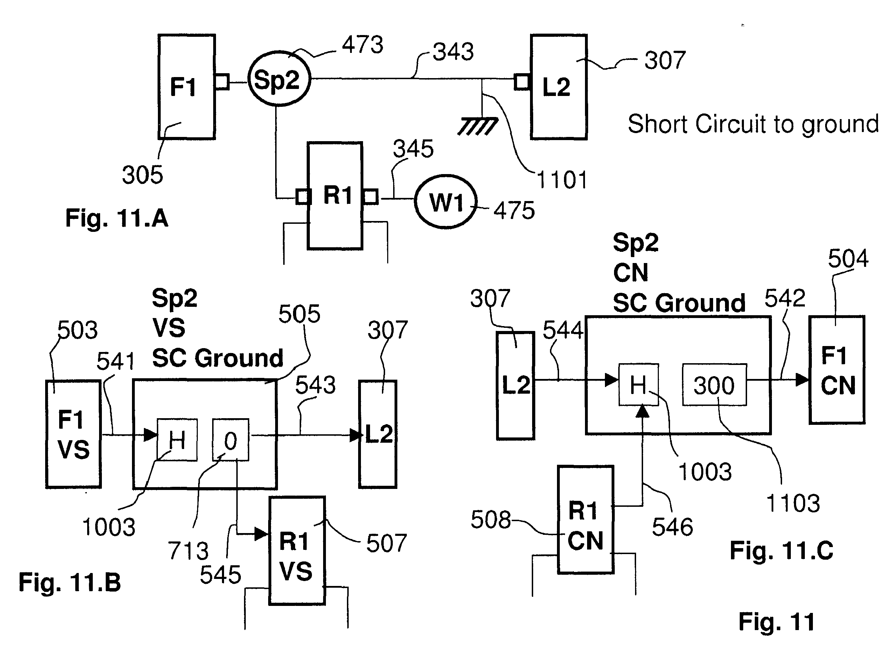

In Figure 11, a short circuit (SC) to ground on a splice is presented. In Figure 11.A, a part of the circuit presented in Figure 4 is recalled. A short circuit to ground is represented through flow 1101. Once the short circuit to ground happens, Load L2 does not receive any more current and all the circuit is affected. We will consider that a short circuit to ground behaves like a load with a very high current demand, whatever the input voltage is. Also, as the voltage of circuit at the short to ground location is null, the value propagated after that point is null. This interpretation is summarized in Figures 11.B and 11.C.

In Figure 11.B, the voltage propagation in splice Sp2 in the presence of a short circuit is specified in outline 505, called "Sp2 VS SC Ground". Voltage supplied through flows 543 and 545 is null (713), in accordance with the effect of short circuit to ground of a wire when that wire resistance is neglected. So input voltage supply flow 541 simply terminates in 1003. In Figure 11.C, the current needed sent on output flow 542 is set to a predefined high value intended to monopolize the battery power. The value may be set higher, however the resistance of the circuit is not null practically.. Similarly, the current needs input flow (544 and 546) of Sp2 CN SC Ground, the interpretation of Sp2 for current propagation, are neglected.

The model presented is a good approximation. However, for a better behavior of the simulation, it is necessary to take into account the impedance of the circuit. For a very accurate simulation, the impedance value at each point of the circuit must be known as explained in Figures 14 to 16.

In Figure 12, the interpretation of corrosion is specified. Corrosion is interpreted as an added resistance to a circuit. In Figure 12.A, we recall a part of the circuit presented in Figure 4 to serve as a basis for the example. In Figure 12.B, the interpretation of wire corrosion is described. The voltage supply propagation outline 1251, called W1 VS-C receives flow 1233 from the current need propagation outline 1253 called W1 CN-C. This flow correspond to a feedback loop to take into account the voltage drop due to the over resistance R, outline 1221, of wire W1. When looking at W1 CN-C, we see that the current need, say I(t), from input flow is transmitted unchanged toward component R1 CN and feedback loop flow 1231. So, in W1 VS-C, the voltage supply coming from R1 VS is lowered due to a voltage Drop (1241 and 1211) of R*I(t) (1213) due to the corrosion of the wire. Finally, the delay block 1215 corresponds to the fact that the simulation can execute only if an initialization of the loop is possible, starting with a null value for instance for the current and taking into account the value of the intensity from the previous loop of computation. This delay block is necessary for an interpretation in Matlab/Simulink. Other tools may not need this delay block.

In each of the cases above, the interpretation of an electrical failure was possible and rather simple and elegant.

So we have illustrated how to interpret electrical failures in our translation. Our approach allows checking the behavior of a circuit in the presence of an exhaustive set of faults:
An open connector will be interpreted as a set of open wires, a corrosion of a connector will be interpreted as a corrosion of some or all the pins of that connector where each pin is interpreted as a wire. An open or short circuit is specified as mentioned above. A relay may stick in either position.
So in the process of validating an electrical circuit, we can automatically generate a model of an electrical circuit and insert automatically any of the possible failures affecting such a circuit.

In Figure 13, we specify a variant for the implementation of a Splice. Rather that interpreting a spliced wire by a unique splice, we rather interpret the splice as the connection between different wires. This means that no fault may be injected on a splice itself but rather on each of the wires connected to that splice. This simplifies the implementation of the interpretation of a splice. So in Figure 13, we see that Splice Sp1 (471), is now connected to wires W1 (1301), W2 (1303) and W3 (1305). Each of these wires serves as an interface between the splice and the components connected. Similarly, splice Sp2 (473), is now connected to wires W4 (1311), W5 (1313) and W6 (1315). Nothing changes in the interpretation of the components. The only change with this interpretation of splices is that we don't need to inject faults in models of splices. This is done exclusively in the models of wires around a splice. The purpose of these remarks is to enable a simpler interpretation of components and faults. It also shows that some slight changes are possible in the interpretation of electrical components without changing the behavior or the method underlined.

In Figure 14, we illustrate the convergence of a simulation according to our method. We have already pointed out that the convergence of a simulation was not trivial and had to be guaranteed; otherwise the simulation is simply meaningless. In Figure 14.A, we consider the case where the source G (1401) is connected to a load which is in fact a pure resistor 1405 of value R2. Furthermore, we consider the case where there is a corrosion of the line corresponding to the insertion of a resistor 1403 of value R1 on the line.

In Figure 14.B, the model corresponding to the automated interpretation of this circuit is presented. The source G is a voltage generator and Load R2 is interpreted as a function of time (noted t) receiving a voltage supply V(t) through flow 1455 and yielding a current needed of value V(t)/R2 through flow 1456. The resistor R1 is interpreted as a feedback loop 1452, corresponding to the injection of a voltage drop (1463) of value R1*I(t) (1461) where I(t) is the current needed 1456.

So if at time t = 0 we start a simulation with voltage V(t) = V on G output 1459. This voltage is propagated to R1 VS. As there is a delay block 1431, the feedback loop sends a null drop on flow 1451 and voltage supplied to the load R2 is V, so the output current flow is V/R2. This current needed is sent back to source G through 1453. For the sake of simplicity, we will consider that G delivers a constant voltage whatever the current needed. For small values of R1 and R2, this hypothesis is perfectly sound.

At time t = 1 (we will discuss the unit time of the simulation later) G delivers again V on flow 1459. But now the feedback loop is active and delivers the value received at t = 0 namely R1*I(t=0) = R1*V/R2= (R1/R2) * V. So the Voltage supplied to load R2 is now (1 - R1/R2)*V. The output flow of load R2 is now (1 - R1/R2)*V/R2

At time t = n+1, the input voltage of load R2 (1455) is V₁₄₅₅(1-R1*I(t=n)). It is easy to show by induction that on V₁₄₅₅(t=n+1) = Σ _{k=0..n} (- R1/R2)^{k}V and I(t=n+1) = Σ _{k=0..n} (-R1/R2)^{k}V/R2. Σ _{k=0..n} (- R1/R2)^{k} is a series which converge only if R1 < R2. Under this condition, the series converges toward R2/(R1+R2). So, in that case, the current needed converges toward V/(R1+R2), which is the right result!

Convergence of the simulations is insured by the voltage supply model. For simple circuits (e.g. when no resistance is considered except in the loads) linear iteration is sufficient. More sophisticated implementations of the voltage supplied can be used in circuits with complex impedance or in simulations where time resolution is imprecise. Figure 15 illustrates such cases.

Figure 15 illustrates the interpretation of wires and splices in the impedance domain. In Figure 15.B, a splice is interpreted as two circuits in parallel. Assume Circuit under block 1501 as impedance Z1 propagated through flow 1511. Assume Circuit under block 1502 has impedance Z2 propagated through flow 1513. Then the impedance resulting of putting these circuits in parallel is (1/ (1/Z1 + 1/Z2)), as can be shown in outline 1503. This computation corresponds to the impedance at splice Sp1: Sp1 IMP and is send forward through flow 1515.

Figure 15.C illustrates the interpretation of a wire. In this interpretation the resistance of the wire, RW1, is not neglected. In most cases, practically, we will consider that this resistance is null as long as the behavior is nominal. The wire W1 is interpreted in Figure 15.C in outline 1507. The impedance on output flow 1523 is the sum of the inner resistance of the wire RW1 and the impedance of the circuit coming from the loads through flow 1521.

All the definitions faithfully correspond to the computation of impedance on a circuit. The Fuses and Relays have an obvious interpretation, very similar to the Current need propagation. Loads impedance must be calculated in advance and for each load, an output impedance flow must be added, carrying the impedance of that load toward the closest component of that load.

In Figure 16, we propose a variant of the interpretation of corrosion, taking into account impedance. As we will see, this interpretation improves the stability of the simulation. In the presence of a resistor on wire W1, we see in outline 509 that the Voltage supply propagation of the wire is now implemented by a function "Drop", outline 1621, taking as input the Voltage supplied from the source through flow 551, the forward loop 1603 and yielding the voltage supplied to load L3 through flow 553. The behavior of the Drop block is to implement a voltage drop taking into account the resistance RW1 of wire W1 and the impedance Z3 of load L3. Here, if V is the voltage supplied on flow 551, (Z3/(Z3 + RW1))*V will be the voltage supplies to load L3 through flow 553. This corresponds to a voltage drop of (RW1/(Z3 + RW1))*V. Taking into account a voltage drop improves the convergence speed. However, taking into account the impedance is not necessary in most cases. The trade-off between the precision and delay of the simulation must only be taken in account.

In Figure 17, we illustrate the structure of a testing environment for an electrical circuit. Here we address the case of a black-box testing environment. Outline 1701 is commonly called the lower tester. It executes a predefined test suite, specified by a system engineer in charge of system validation. This outline is a signal processor taking as input the output of the electrical circuit 1705, and yielding as output both a sound input for the electrical circuit and a testing report. Most commonly known testing environments are hardware environments where the real electrical circuit is checked. However, this scheme perfectly fits the case where both electrical circuit and testing environment are modeled.

We now establish the link between the electrical circuit described in Figure 3 and outline 1705. In Figure 17, outline 1705 has three input flows and two output flows. These flows explicitly or implicitly appear in Figure 3.

Flow 1721 is the flow of user and environment changes. This flow is consumed directly by certain loads of the circuit in Figure 3, namely, the actuators and sensors of the system. For instance, if we consider an electrical brake pedal, flow 1721 consists in a force applied on the pedal, corresponding to a user request in the testing environment. The brake pedal will then appear as a load in Figure 3. So the model of the brake pedal will consume a voltage supply and the force applied by the user on the pedal. That model will yield a current needed and a pedal angle. In that particular case, the current needed may be negligible but the principle is here. Another example is the case of an electrical engine, the front wiping engine for instance. Here, flow 1721 may carry information like temperature and friction force, which will result in an increased power required by the engine. The model of the load corresponding to this electrical engine will receive voltage supply and friction information and will yield a current needed that will increase when the friction increases.

Flow 1723 represents input signals for relays and switches coming from Electronic control units and end users. For instance, the wiper may be controlled by a relay like R1 in Figure 3 and the activation of the wiper may be triggered by flow 351.

Flow 1725 represents triggers for fault injection. Each fault inserted in the Electrical circuit model may be triggered by the test suite. Such triggers allow turning a model of wire in open circuit for instance. This can be performed by the use of standard means in modeling tools like operator Select in "Matlab/Simulink".

Flows 1733 and 1731 represent the feedback loop of the Electrical circuit model toward the testing environment. Flow 1731 represents the signal from sensors, e.g. the pedal angle mentioned in the example above. Flow 1733 represents the feedback of actuators, for instance, the torque delivered by an electrical engine to the environment.

Finally, in Figure 17, flow 1711 carries the Undesired Customer Effects of the system, together with the faults actually injected in the simulation if any. These results are then stored in database 1703. This information is the basis for the construction of diagnose trees that will be use eventually to identify quickly the causes of failures of embedded systems. At development time, this information is used to validate that the system operated properly.

In Figure 18, we present an overall view of the test process. The method takes as input a predefined electrical circuit description 1801, preferably stored in a database. Then predefined models of sources and loads of the electrical circuit are picked up in step 1811. These models may be standard to some extend and reused from one project to another. Current needed models are automatically generated from each electrical component of the electrical distribution: wires, splices, relays and switches, fuses in step 1815. Similarly, impedance models at each component position in the circuit are built in step 1817. In parallel, Voltage supply modes are automatically generated from each electrical component in step 1813. Finally models of failures are inserted in each component in step 1819 so that activation of each failure could be triggered.

Steps 1811, 1813, 1815 and 1817 may be operated in any order. Step 1819 is an add-on of the models specified in steps 1811, 1813, 1815 and 1817.

As already mentioned, step 1817 may be optional in most cases. It improves the convergence of the simulation but at the same time increase the computation load, slowing down the simulation. However, it is a solution to cope with convergence problems when they arise.

All these models are assembled in step 1803, according to the organization of components in the electrical circuit as described in 1801. For instance, if Load L1 is connected to wire L1, their respective models will be connected accordingly as described in Figure 5. Once this model is built, it is integrated with predefined test plan 1805 to yield a self contained testing environment 1821. The test plan is then executed in step 1823 and the results of the test validation are stored in step 1807, preferably in a database. These results can be used to check whether the quality of the design is sufficient for serial production. It can also be used for the purpose of diagnosis.

In Figure 19, we illustrate the implementation of ground links. Up to now, we have presented the electrical distribution of current between the source and the loads. However, if a load misses a ground link, it will fail. As by definition the voltage of a ground is zero, the only electrical failures that must be considered are open circuits and corrosion resulting in a voltage drop for the related loads.

The method of the present invention may be implemented by a computer that is configured to implement the various steps of the method and thereby ultimately to automatically output a validation environment for use in proving a design proposed for an embedded electrical system. The validation environment would preferably be recorded in a computer readable memory device that would then subsequently be used by a computer aided design tool to validate designs proposed for the or each service concerned, such a design tool comprising either the same or a different computer.

The method steps may be commercialized in particular by being recorded onto an article of commerce in the form of a computer readable memory, for example a CD, DVD or equivalent or directly on to the hard disk of a design tool. The method might then be recorded on that memory device as a computer program readable and executable by the computer/design tool concerned.

## Claims

1. A method for designing a validation environment for a service implemented by an embedded electrical system, the method including:
a) defining the boundaries of said embedded system;
b) assigning to each device interfaced in use to said system a respective first model, said first model representing the behavior of its associated device;
c) generating automatically a skeleton validation environment around said service and connecting said skeleton validation environment to said interface devices, said skeleton validation environment covering substantially all user requests and resultant system responses of said service;
d) assigning to each electrical source inside said system a respective second model, whose input is a current intensity request (CN) and whose output is a voltage supplied (VS) by said electrical source;
e) assigning automatically to each component of the electrical distribution arrangement of said system, a respective third model representative of the behavior of its associated said distribution component;
f) assigning to each undesired event or behavior of the system a respective fourth model, for which the inputs are all the available signals corresponding to interfaced devices and for which the output signals indicate the occurrence of said undesired event or behavior;
g) connecting all of said first to fourth models together through said skeleton validation environment; and
h) executing test scenarios, said method preferably also including the step of recording from the results of said test scenarios the occurrences of undesired behavior resulting from an undesired event or fault.

2. A method according to claim 1, wherein said interfaced devices include at least one selected from the group including; mechanical, optical, hydraulic, pneumatic or thermal devices.

3. A method according to claim 1 or claim 2, including injection of simulated faults, corresponding for example to a short circuit in the case of wiring, an increased resistance due to corrosion for connectors or an open circuit.

4. A method according to any preceding claim, including outputting a design of a validation environment for use in adaptation of a design tool to perform validation testing of a said embedded electrical system.

5. A method according to any preceding claim, including substituting one or more of said models with a corresponding software implementation and performing software-in-the-loop testing so as to validate the software implementation.

6. A method according to any preceding claim, including substituting one or more of said models with a corresponding hardware implementation and performing hardware-in-the-loop testing so as to validate the hardware implementation.

7. A method according to claim 6, including producing a design of a wiring harness for a vehicle and using said hardware-in-the-loop environment for validating the specification of wiring and connectors.

8. A computer readable memory having encoded thereon a program for the design of a validation environment for a service implemented by an embedded electrical system, **characterized in that** said program includes:
a) code for defining the boundaries of said embedded system;
b) code for assigning to each device interfaced in use to said system a respective first model, said first model representing the behavior of its associated device;
c) code for generating automatically a skeleton validation environment around said service and connecting said skeleton validation environment to said interface devices, said skeleton validation environment covering substantially all user requests and resultant system responses of said service;
d) code for assigning to each electrical source inside said system a respective second model, whose input is a current intensity request (CN) and whose output is a voltage supplied (VS) by said electrical source;
e) code for assigning automatically to each component of the electrical distribution arrangement of said system, a respective third model representative of the behavior of its associated said distribution component;
f) code for assigning to each undesired event or behavior of the system a respective fourth model, for which the inputs are all the available signals corresponding to interfaced devices and for which the output signals indicate the occurrence of said undesired event or behavior;
g) code for connecting all of said first to fourth models together through said skeleton validation environment; and
h) code for executing test scenarios, preferably further including code for recording from the results of said test scenarios the occurrences of undesired behavior resulting from an undesired event or fault.

9. An item of commerce according to claim 8, further including code for the injection of simulated faults, corresponding for example to a short circuit in the case of wiring, an increased resistance due to corrosion for connectors or an open circuit.

10. A design tool adapted for the validation of a system design, said design tool being arranged in use to output a validation environment for an embedded electrical system by using a method according to any one of claims 1 to 7, or through being programmed using an article of commerce according to claim 8 or claim 9.
